# EUROPEAN PATENT SPECIFICATION

(11) **EP 0 331 282 B1**
(45) Date of publication and mention of the grant of the patent: **13.10.1993**
(21) Application number: 89300688.2
(22) Date of filing: 25.01.1989
(51) Int. Cl.: G01R 1/073

(54) **Membrane-based IC test probe with precisely positioned contacts**
IC-Testsonde auf Membranbasis mit präzise positionierten Kontakten
Sonde de test pour circuits imprimés avec des contacts positionnés de façon exacte sur la base d'une membrane

(30) Priority: 01.03.1988 US 162763
(43) Date of publication of application: 06.09.1989
(73) Proprietor: Hewlett-Packard Company, Palo Alto, California 94304 (US)
(72) Inventor: Foster, Jack, D., Los Altos California 94022 (US); Greenstein, Michael, Los Altos California 94022 (US); Huff, Richard, Belmont California (US); Leslie, Brian C., Cupertino California 95401 (US); Matta, Farid, Mountain View California 94040 (US)
(74) Representative: Colgan, Stephen James

(56) References cited:
- EP-A- 0 226 995
- US-A- 4 065 717
- US-A- 4 649 339

## Description

### BACKGROUND OF THE INVENTION

The present invention relates to test probes for testing integrated circuits. A major objective of the present invention is to provide a test probe with more precisely controlled contact registration and a method of making the same.

Semiconductor processing technology has provided for the manufacture of small, complex integrated circuits. These integrated circuits can be processed in batches on a single semiconductor wafer. The cost of fabricating an integrated circuit is low relative to the cost of packaging individual devices and integrating them into systems. Depending on circuit complexity and the processing technology employed, the manufacturing yield for a device can vary considerably, e.g., from 0% to 100% of devices on a wafer may be fully functional.

Since it is costly to test an integrated circuit after packaging, and even more costly to test after incorporation of a packaged integrated circuit into a system, test instruments have been designed to test integrated circuits while still on the wafers on which they were fabricated. Typically, test probes physically and electrically contact bonding pads on an integrated circuit to provide the electrical coupling required for evaluating its functionality.

Test probes have had to evolve to keep pace with rapidly advancing integrated circuit technology. Tests probes have been designed with wires cantilevered radially inward and downward to contact bonding pads on an integrated circuit die. Typically, these are the same bonding pads used to couple the die electrically with a package which protects and provides interfacing for the integrated circuit. It has not proved practicable to develop wire-based probes with sufficiently thin and numerous wires to test today's most highly integrated circuits.

The thin film techniques used to manufacture integrated circuits have been adapted to the fabrication of test probes suitable for more highly integrated circuits. Devices using such techniques or related techniques are disclosed in "Film Supported Probe For The AC Pulse Testing of Integrated Circuits" by F.H. Dill and R.J. Rosalli, *IBM Technical Disclosure Bulletin, Vol. 10*, No. 10, March 1968, and in U.S. Patent No. 4,636,722 to Adezzone. Contacts can be formed lithographically on a membrane in positions matching the positions of contact pads on a die to be tested. Either before, during, or after contact formation, conductive leads are formed extending from the contact positions radially outward.

A carrier board can be glued to the membrane. An annular translation stage is positioned within the carrier board and frictionally contacts an annular membrane region enclosing the contacts. The translation stage is pushed against the membrane so that the region enclosed by the translation stage protrudes relative to the carrier board. This ensures that the contacts can contact the bonding pads of the die without physical interference caused by contact of the membrane with areas of the wafer away from the die under test. A lens assembly with an elastomeric spring is pressed against the contact region of the membrane to force the contacts against the pads during testing. A window is situated to confine the lens assembly, pressing it against the membrane, and to provide for visual alignment of contacts and pads.

While successfully overcoming the limitations of wire-based test probes, available membrane-based test probes have had their capabilities exceeded by further advances in integrated circuit technology. Applicants have found that, as bonding pad size is decreased and as die size is increased, it becomes more difficult to mate die and test probe successfully. Applicants' studies have indicated that one major source of probe-to-die mismatch is the displacement of probe contacts due to elastic deformation of the membrane when the translation stage is protruded from the plane of the carrier board.

In US-A-4649339, an integrated circuit interface is described which comprises a membrane having contacts arranged to match contact pads on an integrated circuit die. Conductors extend from the contacts for connection to a test circuit. An apparatus is used for flexing the membrane so that it forms a generally domed shape, whereby contacts on the membrane and die are brought into intimate contact. A conically shaped surface of the apparatus holds the membrane so that the membrane forms the required shape, whilst an upper portion of the apparatus fits an upper portion of the membrane, holding it in position.

EP-A-0226995 discloses a probe assembly which also includes a membrane having contacts distributed in an arrangement matching contacts of the integrated circuit which is to be tested. A support member holds the membrane and includes conductors which extend from contacts on the membrane for connection to testing apparatus.

According to the invention, there is provided a device comprising: a membrane including an enclosed region, an annular region, an outer region and a peripheral region in radially outward succession; electrical elements formed on said membrane, said electrical elements including contacts located within said enclosed region and leads extending from respective ones of said contacts radially outward through said annular region; a carrier bonded to said membrane at said peripheral region; a translation stage bonded at said annular region of said membrane and enclosing said enclosed region; holding means for holding said translation stage in a predetermined position relative to said carrier in a direction perpendicular to said enclosed region so that said enclosed region is deformed to a substantially lesser extent than said outer region; and a central pattern formed on a central subregion of said enclosed region, said membrane having greater elasticity than said central pattern so that when said translation stage is moved relative to said carrier said contacts do not move significantly relative to each other.

According to a further aspect of the present invention, there is provided a method for making such a device comprising: obtaining a membrane having a central region, an inner region, an annular region, an outer region and a peripheral region in radially outward succession, said regions being mutually exclusive except for common boundaries; disposing said membrane in a planar configuration including all of said regions; forming on said membrane contacts and leads so that said leads are electrically coupled to and extending radially outward from respective ones of said contacts, said contacts being formed on said inner region; attaching a carrier to said peripheral region of said membrane; bonding a translation stage to said annular region of said membrane; and in which said forming step further includes forming a pattern within said central region using a material of lesser elasticity than said membrane so that said pattern constrains the relative movement of said contacts during said moving step such that the translation stage when moved orthogonally with respect to said central region and relative to said carrier, the extent of deformation of said membrane in said outer region substantially exceeds the extent of deformation in said central and inner regions.

The present invention provides for the constraint of relative movement between contacts during the protrusion of the translation stage. This is done primarily by bonding the translation stage to the membrane so that the membrane region enclosed by the translation stage stretches less than the region outside the translation stage during its protrusion. The approach can be supplemented by forming a rigid pattern within a central region extending near but excluding the contacts on the membrane. This pattern can be dedicated to maintaining contact positions only, or also serve an additional purpose such as height sensing or probe alignment. In addition, the contacts can be positioned initially to precompensate for subsequent relative movements.

These provisions ensure a membrane-based test probe with more precisely controlled contact positions. Since the contact positions can be more accurately matched to the bonding pad positions on a die under test, the mating of probe and die is greatly facilitated. In particular, advanced integrated circuits with increased die sizes and smaller die bonding pads can be tested reliably and conveniently.

Preferred embodiments of test probe will now be described, with reference to the drawings in which:
FIGURE 1 is a sectional view of a test probe in accordance with the present invention.
FIGURE 2 is a plan view of the test probe of FIG. 1 with portions cutaway.
FIGURE 3 is a sectional view of a portion of the test probe of FIG. 1.
FIGURE 4 is a plan view of a portion of the test probe of FIG. 1.
FIGURE 5 is a plan view of a portion of another test probe in accordance with the present invention.

### DESCRIPTION OF THE PREFERRED EMBODIMENTS

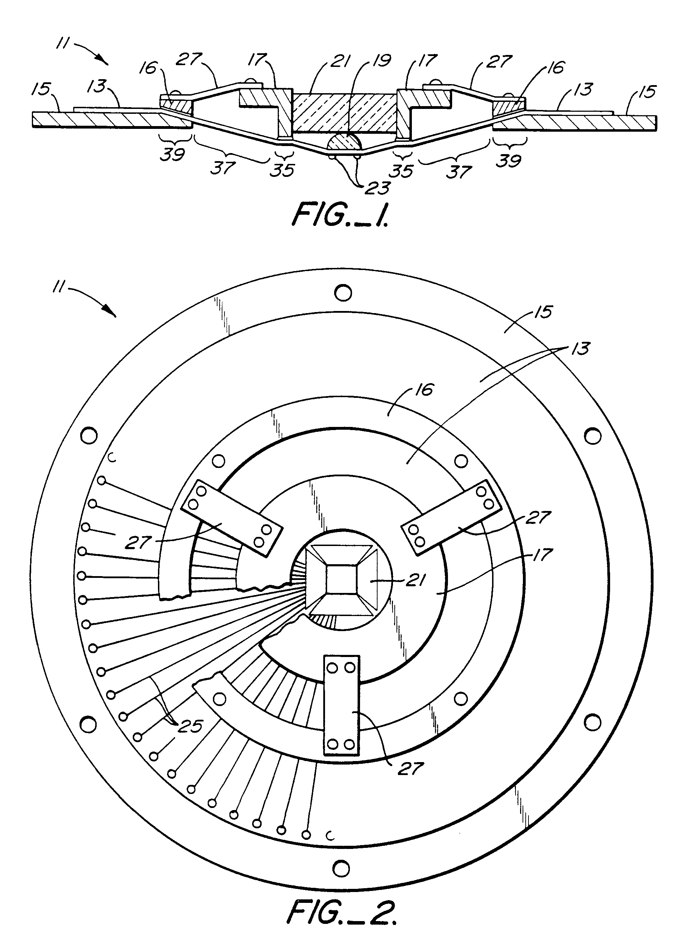

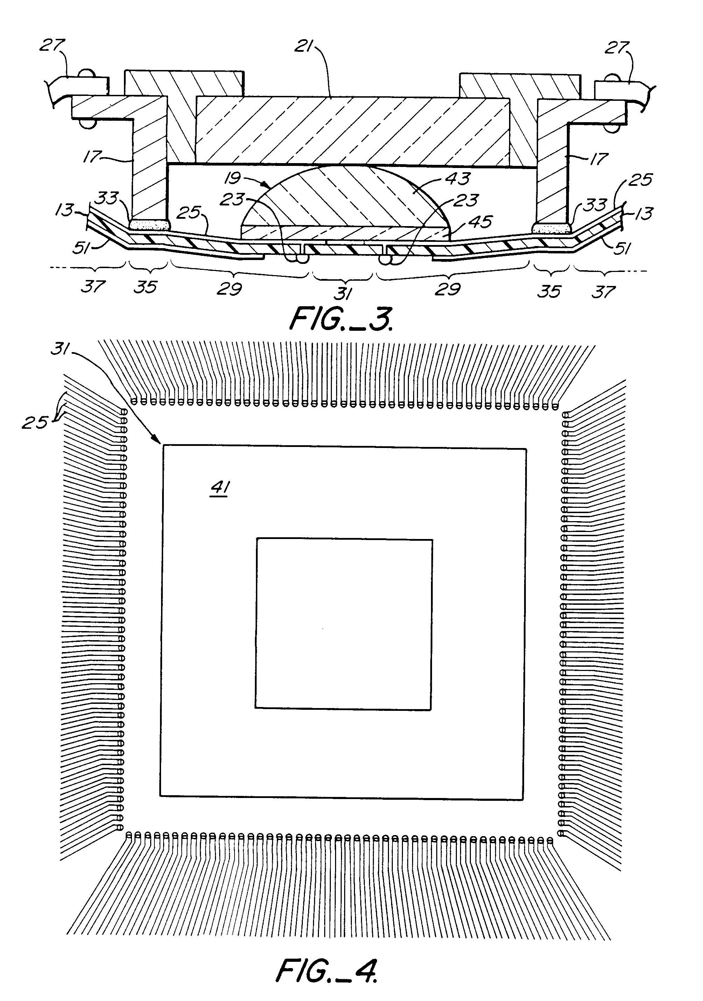

A membrane-based test probe 11 comprises a membrane 13, a carrier 15, an insulator ring 16, a translation stage 17, a lens assembly 19 and an alignment window 21, as shown in FIGS. 1 and 2. Fabricated on membrane 13 are contacts 23 and associated leads 25, shown in FIGS. 2 and 3. Contacts 23 are positioned to mate with bonding pads on an integrated circuit die. The electrical functionality of the die can be tested by a circuit analyzer using test probe 11 as an interface.

Typically, the die under test is one of many fabricated on a wafer of silicon or other semiconductor material. To ensure probe 11 does not contact adjacent dies, its center is protruded by translation stage 17 from the plane defined by carrier 15. The position of translation stage 17 relative to carrier 15 is maintained by three leaf springs 27. Translation stage 17 encircles and maintains the protruded position for the membrane's inner region 29, which bears contacts 23, and the membrane's central region 31, which is radially inward of contacts 23, as shown in FIG. 3.

During fabrication of probe 11, contacts 23 and leads 25 are formed while membrane 13 is flat. Translation stage 17 is used to protrude inner region 29 and central region 31 from their positions prior to translation. Membrane 13 necessarily stretches to accommodate this protrusion. As shown in FIG. 3, translation 17 is bonded to membrane 13 with glue 33 along an annular region 35 of membrane 13. Translation stage 17 is considerably less flexible than membrane 13 and thus constrains expansion of regions 29 and 31 enclosed by it. Stretching to accommodate protrusion is thus largely confined to an outer region 37 of membrane 13 between annular region 35 to which translation stage 17 is glued and a peripheral region 39, FIG. 1, of membrane 13 to which carrier 15 is glued.

In reference to FIG. 3, since stretching is minimized in inner region 29, contacts 23 formed thereon substantially maintain their original positions during and after the translation procedure. Without such constraint, contacts 23 would not only move, but move in relatively unpredictable amounts since, generally, the elastic deformation forced by the protrusion would be non-uniform.

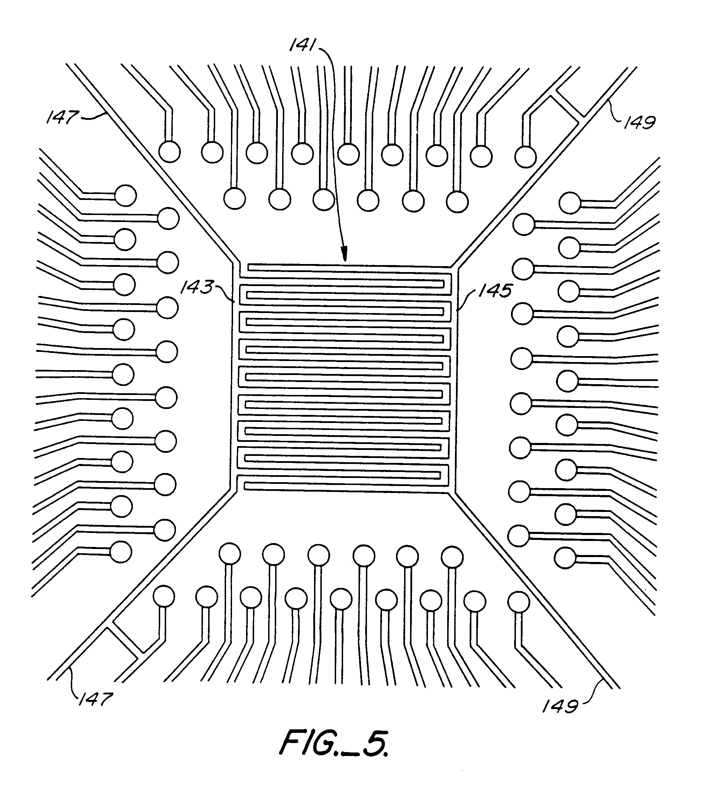

Contact position control can be further enhanced by including a pattern in central region 31 radially inward from contacts 23. FIG. 4 shows a rectangular pattern 41 formed in central region 31. This pattern 41 can be formed conveniently in the same steps used in defining leads 25. Being a closed pattern of material more rigid than membrane 13, rectangular pattern 41 serves to further constrain the movement of contacts 23 from the membrane center and relative to each other during protrusion. As used herein, "rectangular" includes "square" as a special case.

In an alternative embodiment, shown in FIG. 5, a central pattern 141 serves a function other than dimensional stability. The basically rectangular center pattern 141 comprises two capacitively coupled interdigitated electrical elements 143 and 145. Each element 143, 145 has an associated pair of leads 147, 149. Element 143 is used as a signal source and its leads 147 are used to provide a sine wave input to pattern 141. Element 145 is used as a signal sensor and its leads 149 transmit a detected signal to a signal strength detector (not shown). Signal amplitude is at a minimum in the absence of a device under test. As a die is raised toward the contacts, capacitance increases and the detection signal amplitude increases. A predetermined signal amplitude threshold can be used to indicate the position of die with respect to probe 11. Thus a signal output by element 145 can be compared with a threshold to determine when a die is properly positioned for electrical testing.

In other embodiments, pattern can be used for alignment of the probe with features on the die other than die bonding pads. This can be helpful when small die bonding pads are obscured by mating contacts to an extent rendering proper registration impracticable.

While gluing of translation stage 17 and the use of the rigid pattern 41 in the central region can limit relative contact displacement sufficiently to allow testing larger and more densely integrated dies than heretofore practicable, these techniques cannot eliminate such displacement entirely. However, these techniques confine stretching to make its effects predictable. Thus, it becomes practicable to precompensate for the stretching. In other words, the contacts can be fabricated more closely together than required during testing so that, upon protrusion and concomitant stretching, contacts 23 assume the relative positions required for mating even a very large die with very small die bonding pads.

Test probe 11 can be manufactured according to the following procedure. First a membrane "blank" is obtained and the desired conductive pattern is formed thereon. The membrane material can be purchased or fabricated with a conductive layer on an insulating flexible material, such as polyimide. Leads 25 and central pattern 41 can be defined in the conductive layer using photo-lithography. A ground plane 51, shown in FIG. 3, can be added, for example, by sputtering a metal onto the side of membrane 13 opposite leads 25. To form contacts 23, holes are drilled into membrane 13 using a laser milling technique. The holes are then filled by plating to form contacts 23. Membrane 13 is then bonded to carrier 15. This connection is made using vias plated into holes drilled into membrane 13. The carrier conductors are connected to an external contact pad to which test circuitry connects.

Translation stage 17 can be glued to annular region 35 of the patterned membrane 13. Then translation stage 17 is moved relative to carrier 15 in a direction orthogonal to the plane of membrane 13. As a result of this translation, while outer region 37 assumes a conical form illustrated in FIG. 1. Inner region 29 and central region 31 substantially maintain their forms through the translation. Inner region 29 is slightly articulated due to the force of lens assembly 19 on membrane 13, while central region 31 is essentially planar.

Since annular region 35 is glued to the relatively rigid translation stage 17, regions 29 and 31 enclosed thereby are constrained from expanding. Therefore, the additional area required as outer region 37 assumes a conical form is provided primarily by stretching outer region 35 with negligible stretching of inner region 29 and central region 31. Thus, the gluing of translation stage 17 to annular region 35 helps preserve the relative positions of contacts 23 through the translation process.

Just as the gluing of translation stage 17 serves to minimize relative contact displacement due to the force of the translation stage on membrane 13, a central rectangular pattern 41 can be used to minimize relative displacement of contacts 23 due to the force of lens assembly 19. Lens assembly 19 includes a self-leveling lens 43 and a disc-shaped elastomeric spring 45. The hemispherical shape of self-leveling lens 43 allows it to rotate to maintain gross planarity of elastomeric spring 45 with membrane 13, while the elastomeric spring 45 deforms as necessary to uniformly distribute force over its region of contact with membrane 13. The action of lens assembly 19 protrudes central region 31 from inner region 29 so that the latter does not interfere with the mating of contacts 23 with a device under test. Rectangular pattern 41 helps to maintain the relative position of contacts 23 despite the application of force by lens assembly 19.

In addition, the mechanical isolation of regions 29 and 31 by translation stage 17 is not perfect so rectangular pattern 41 further constrains on the movement of contacts 23 due to the action of translation stage 17. Specifically, rectangular pattern 41 minimizes local non-uniformities that can cause the contacts to move irregularly with respect to each other so that the basic configuration of contacts 23 is not distorted even though a small amount of expansion can occur.

Since a test probe manufactured using the foregoing techniques exhibits predicable contact displacements, these displacements can be precompensated by locating the contacts during patterning a small amount radially inward of the desired ultimate contact positions. As incorporated in the present invention, this isotropic precompensation step is more effective than when applied without the constraining steps. In the case of an unbonded translation stage, local non-uniformities in membrane expansion limit the effectiveness of precompensation because of variable relative contact movements and changes in contact pattern shape.

In accordance with the foregoing, an improved test probe and method for making the same provide for more precise control of probe contact placement. The present invention provides for many alternatives to the preferred embodiments described above. The translation stage can take many alternative forms and can be bonded to the membrane using different methods, including gluing, fusing, tacking, and otherwise mechanically attaching. The translation stage and membrane carrier can be attached in a variety of ways. The central patterns can serve various secondary functions such as alignment, height sensing, etc. The fabricating steps can be performed according to a range of techniques and sequences. These and other modifications and variations are provided for by the present invention, the scope of which is limited only by the following claims.

## Claims

1. A device (11) comprising:
a membrane (13) including an enclosed region (29, 31), an annular region (35), an outer region (37) and a peripheral region (39) in radially outward succession;
electrical elements formed on said membrane, said electrical elements including contacts (23) located within said enclosed region and leads (25) extending from respective ones of said contacts radially outward through said annular region;
a carrier (15) bonded to said membrane at said peripheral region;
a translation stage (17) bonded at said annular region of said membrane and enclosing said enclosed region;
holding means (27) for holding said translation stage in a predetermined position relative to said carrier in a direction perpendicular to said enclosed region so that said enclosed region is deformed to a substantially lesser extent than said outer region; and
a central pattern (41, 141) formed on a central subregion (31) of said enclosed region, said membrane having greater elasticity than said central pattern so that when said translation stage is moved relative to said carrier, said contacts do not move significantly relative to each other.

2. A device according to claim 1, wherein said central pattern includes a pair of capacitively coupled electrical elements (143, 145).

3. A device according to claim 1 or claim 2, further comprising a lens means (19) situated within said translation stage and in contact with said central region.

4. A device according to claim 3, further comprising a window (21) disposed on said lens means.

5. A method for making the device of Claim 1 comprising:
obtaining a membrane (13) having a central region (31), an inner region (29), an annular region (35), an outer region (37) and a peripheral region (39) in radially outward succession, said regions being mutually exclusive except for common boundaries;
disposing said membrane in a planar configuration including all of said regions.
forming on said membrane contacts (23) and leads (25) so that said leads are electrically coupled to and extending radially outward from respective ones of said contacts, said contacts being formed on said inner region;
attaching a carrier (15) to said peripheral region of said membrane;
bonding a translation stage (17) to said annular region of said membrane; and said forming step further includes forming a pattern (41, 141) within said central region using a material of lesser elasticity than said membrane so that said pattern constrains the relative movement of said contacts during said moving step
the translation stage such that when moved orthogonally with respect to said central region and relative to said carrier, the extent of deformation of said membrane in said outer region substantially exceeds the extent of deformation in said central and inner regions.

6. A method according to claim 5, further comprising a step of inserting a lens means (19) in said translation stage and pressing said lens means against said central and inner regions.

7. A method according to claim 5 or claim 6, further comprising a compensating step of determining the positions required for positioning said contacts during said forming step so that said contacts attain predetermined positions after said moving step.

8. A method according to any one of claims 5 to 7, wherein said pattern is formed of two capacitively coupled electrical elements (143, 145).

## Patentansprüche

1. Vorrichtung, welche umfaßt:
eine Membran (13), welche in radialer Abfolge nach außen einen eingeschlossenen Bereich (29, 31), einen ringförmigen Bereich (35), einen äußeren Bereich (37) und einen peripheren Bereich (39) enthält,
auf der Membran ausgebildete elektrische Elemente, wobei diese elektrischen Elemente Kontakte (23), die sich innerhalb des eingeschlossenen Bereichs befinden, und Leitungen (25) einschließen, die sich von den entsprechenden Kontakten radial nach außen durch den ringförmigen Bereich erstrecken,
einen Träger (15), der mit der Membran in dem peripheren Bereich verbunden ist,
ein Verschiebegestell (17), das an dem ringförmigen Bereich der Membran verbunden ist und den eingeschlossenen Bereich umschließt,
eine Halteeinrichtung (27) zum Halten des Verschiebegestells in einer vorbestimmten Position relativ zu dem Träger in einer Richtung senkrecht zu dem eingeschlossenen Bereich, so daß der eingeschlossene Bereich in einem wesentlich geringeren Ausmaß deformiert wird als der äußere Bereich, und
ein zentrales Muster (41, 141), das in einem zentralen Unterbereich (31) des eingeschlossenen Bereichs ausgebildet ist, wobei die Membran eine größere Elastizität als das zentrale Muster hat, so daß dann, wenn das Verschiebegestell relativ zu dem Träger bewegt wird, sich die Kontakte relativ zueinander nicht wesentlich bewegen.

2. Vorrichtung nach Anspruch 1, bei der das zentrale Muster ein Paar von kapazitiv gekoppelten elektrischen Elementen (143, 145) enthält.

3. Vorrichtung nach Anspruch 1 oder Anspruch 2, welche weiterhin eine Linseneinrichtung (19) umfaßt, die innerhalb des Verschiebegestells gelegen ist und in Kontakt mit dem zentralen Bereich steht.

4. Vorrichtung nach Anspruch 3, welche weiterhin ein Fenster (21) umfaßt, das auf der Linsenvorrichtung angeordnet ist.

5. Verfahren zum Herstellen der Vorrichtung nach Anspruch 1, welches umfaßt:
Erlangen einer Membran (13), die in radialer Abfolge nach außen einen Zentralbereich (31), einen inneren Bereich (29), einen ringförmigen Bereich (35), einen äußeren Bereich (37) und einen peripheren Bereich (39) aufweist, wobei sich diese Bereiche, abgesehen von gemeinsamen Grenzen, gegenseitig ausschließen,
Anordnen dieser Membran in einer ebenen Anordnung, welche alle genannten Bereiche umfaßt,
Bilden von Kontakten (23) und Leitungen (25) auf der Membran, so daß die Leitungen elektrisch mit entsprechenden Kontakten verbunden sind und sich radial nach außen von diesen erstrecken, wobei die Kontakte auf dem inneren Bereich gebildet werden,
Befestigen eines Trägers (15) an dem peripheren Bereich der Membran,
Verbinden eines Verschiebegestells (17) mit dem ringförmigen Bereich der Membran,
und bei dem der Schritt des Bildens weiterhin das Bilden eines Musters (41, 141) innerhalb des zentralen Bereichs unter Verwendung eines Materials mit geringerer Elastizität als der Membran umfaßt, so daß das Muster die relative Bewegung der Kontakte während des Schritts des Bewegens derart einschränkt, daß dann, wenn das Verschiebegestell orthogonal bezüglich des Zentralbereichs und relativ zu dem Träger bewegt wird, das Ausmaß der Deformation der Membran in dem äußeren Bereich das Ausmaß der Deformation in dem zentralen und dem inneren Bereich wesentlich übersteigt.

6. Verfahren nach Anspruch 5, welches weiterhin einen Schritt des Einfügens einer Linseneinrichtung (19) in das Verschiebegestell und des Pressens der Linseneinrichtung gegen den zentralen und den inneren Bereich umfaßt.

7. Verfahren nach Anspruch 5 oder 6, welches weiterhin einen kompensierenden Schritt des Bestimmens der Positionen umfaßt, welche zum Positionieren der Kontakte während des Schritts des Bildens erforderlich sind, so daß die Kontakte in vorbestimmte Positionen nach dem Schritt des Bewegens gelangen.

8. Verfahren nach einem der Ansprüche 5 bis 7, bei dem das Muster aus zwei kapazitiv gekoppelten elektrischen Elementen (143, 145) gebildet wird.

## Revendications

1. Dispositif (11) comportant:
une membrane (13) contenant une région close (29, 31), une région annulaire (35), une région externe (39) se succédant de façon radiale vers l'extérieur;
des éléments électriques formés sur ladite membrane, lesdits éléments électriques incluant des contacts (23) situés à l'intérieur de ladite région close et des fils (25) s'étendant vers l'extérieur de façon radiale depuis des contacts respectifs desdits contacts, à travers ladite région annulaire;
un support (15) lié à ladite membrane sur ladite région périphérique;
un étage de translation (17) lié à ladite région annulaire de ladite membrane et entourant ladite région close;
un moyen de maintien (27) destiné à maintenir ledit étage de translation dans une position prédéterminée par rapport audit support dans une direction perpendiculaire à ladite région close afin que ladite région close soit déformée dans une mesure sensiblement plus faible que ladite région externe; et
un motif central (41, 141) formé sur une sous-région centrale (31) de ladite région close, ladite membrane ayant une plus grande élasticité que ledit motif central, de sorte que lorsque ledit étage de translation est déplacé par rapport audit support, lesdits contacts ne se déplacent pas de façon significative les uns par rapport aux autres.

2. Dispositif selon la revendication 1, dans lequel ledit motif central comporte une paire d'éléments (143, 145) électriquement couplés de façon capacitive.

3. Dispositif selon la revendication 1 ou la revendication 2, comportant en outre un moyen de lentille (19) situé à l'intérieur dudit étage de translation et en contact avec ladite région centrale.

4. Dispositif selon la revendication 3, comportant en outre une fenêtre (21) située sur ledit moyen de lentille.

5. Procédé de réalisation du dispositif de la revendication 1 comportant:
l'obtention d'une membrane (13) possédant une région centrale (31), une région interne (29), une région annulaire (35), une région externe (37) et une région périphérique (39) se succédant de façon radiale vers l'extérieur, lesdites régions étant mutuellement exclusives à l'exception des limites communes;
la disposition de ladite membrane dans une configuration planaire contenant l'ensemble desdites régions.
la formation sur lesdits contacts de membrane (23) et de fils (25) de sorte que les fils soient couplés électriquement à et s'étendent de façon radiale vers l'extérieur depuis des contacts respectifs desdits contacts, lesdits contacts étant formés sur ladite région interne;
la fixation d'un support (15) à ladite région périphérique de ladite membrane;
la liaison d'un étage de translation (17) à ladite région annulaire de ladite membrane et ladite étape de formation comportant en outre la formation d'un motif (41, 141) à l'intérieur de ladite région centrale, en utilisant un matériau de moindre élasticité que ladite membrane, de sorte que ledit motif contraigne le mouvement relatif desdits contacts durant ladite étape de déplacement, telle que lorsque l'étage de translation est déplacé orthogonalement par rapport à ladite région centrale et par rapport audit support, l'importance de la déformation de ladite membrane dans ladite région externe excède sensiblement l'importance de la déformation dans lesdites régions centrale et interne.

6. Procédé selon la revendication 5, comportant en outre une étape d'insertion d'un moyen de lentille (19) dans ledit étage de translation et la pression dudit moyen de lentille contre lesdites régions centrale et interne.

7. Procédé selon la revendication 5 ou la revendication 6, comportant en outre une étape compensatrice de détermination des positions exigées pour le positionnement desdits contacts durant ladite étape de formation, de sorte que lesdits contacts atteignent des positions prédéterminées après ladite étape de déplacement.

8. Procédé selon l'une quelconque des revendications 5 à 7, dans lequel ledit motif est formé de deux éléments (143, 145) électriques couplés de façon capacitive.
